# EUROPEAN PATENT SPECIFICATION

(11) **EP 2 441 154 B1**
(45) Date of publication and mention of the grant of the patent: **10.07.2019**
(21) Application number: 10786440.7
(22) Date of filing: 20.05.2010
(51) Int. Cl.: H02J 7/00, H02J 7/14

(54) **CHARGING DURATION DETERMINATION**
LADUNGSDAUERBESTIMMUNG
DÉTERMINATION D'UNE DURÉE DE CHARGE

(30) Priority: 09.06.2009 SE 0950423
(43) Date of publication of application: 18.04.2012
(73) Proprietor: Scania CV AB, 151 87 Södertälje (SE)
(72) Inventor: LEDFELT, Gunnar, S-155 91 Nykvarn (SE)
(74) Representative: Scania CV AB
(86) International application number: PCT/SE2010/050547
(87) International publication number: WO 2010/144023

(56) References cited:
- EP-A2- 0 753 925
- EP-A2- 0 753 925
- EP-A2- 1 093 974
- DE-A1- 4 414 134
- DE-A1- 19 831 723
- US-A- 5 525 891
- US-A- 5 726 553

## Description

### Field of the invention

The present invention relates to a method for determining a resulting charging duration to be used for charging at least one starter battery in a dual battery system as defined in the preamble of claim 1.

The present invention also relates to a computer program, executing the steps of the methods, as defined in the preamble of claim 16

The present invention also relates to an arrangement for determining a resulting charging duration to be used for charging at least one starter battery in a dual battery system as defined in the preamble of claim 18.

### Related art and background of the invention

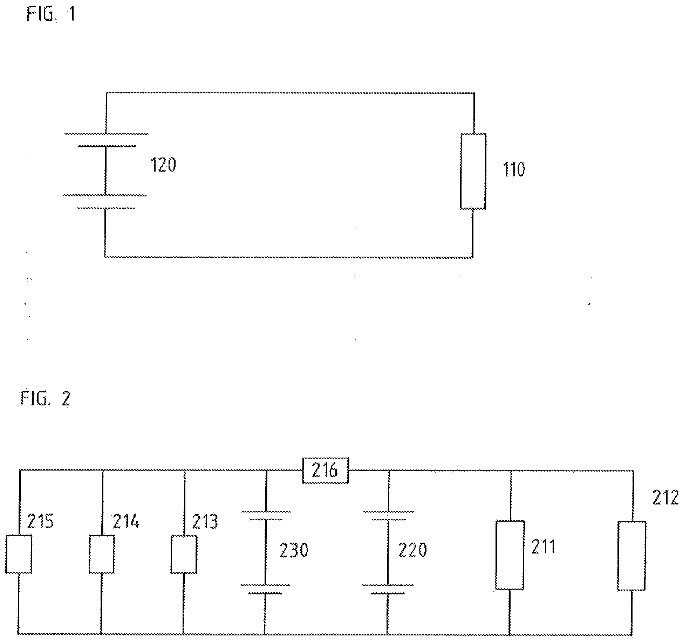

In vehicles, such as cars, trucks, tractors, and the like, as well as in vessels, such as ships and boats, motors and engines are used for driving the vehicles or vessels. When starting these motors, an electrically driven starter motor is usually used for cranking the motor until it runs by itself, i.e. without being driven by the starter motor. Figure 1 schematically shows a traditional battery system for e.g. a vehicle or a vessel, in which at least one Starting, Lighting and Ignition (SLI) battery 120 is used for providing Direct Current (DC) voltage to an electrical system 110, wherein the electrical system 110 includes the starter motor, a generator and a number of other electrical devices consuming DC current. These electrical devices include, for example, microprocessors, driver compartment heating systems, lights, audio systems, and video systems. Some of these devices may be used when the motor is not running, and will then be driven by DC voltage from the at least one SLI battery 120. Here, the SLI battery 120 generally has two functions, one function being to start the motor, by driving the starter motor, and the other function being to provide the electrical devices with electricity when the motor is not running.

Therefore, the at least one SLI battery 120 should be able to provide sufficient electrical power for both of these two functions. Thus, the at least one SLI battery 120 of the traditional battery system has to have both a high power and a good cycling capacity. High power is needed for the SLI battery to be able to drive the starter motor. Cycling capacity is needed, such that it can be run down and recharged a large number of times, due to usage of electrical devices when the motor is not running. Typically, high power abilities and good cycling capacity are contradictory features for batteries. Thus, for the traditional battery system used in figure 1, a compromise between these two features have to be found, such that the SLI battery can be used for both of these functions. The at least one SLI battery 120 is therefore normally designed so as to provide a battery being balanced between these two features. However, this leads to a suboptimal use of the at least one SLI battery 120, since it cannot be optimized for both of the functions.

Figure 2 shows a prior art battery system having at least one power battery 220 and at least one starter battery 230, each providing electrical power for different purposes. Here, the at least one power battery 220 provides DC voltage to electrical devices being used when the motor is not running, such as lights 211 and heating systems 212. The at least one starter battery 230 provides electrical power to the starter motor 213. A generator 214 is used for charging the batteries. An Engine Management System (EMS) 215 controls the starter motor 213. An interconnection device 216 is needed such that both batteries can be charged by the generator 214.

However, the system shown in figure 2 has the drawback of quiescent currents discharging the starter battery 230 through the EMS 215. Also, the interconnection device 216 is often implemented as a diode, for which case the power from the power battery 220 cannot be utilised for activating the starter motor 213.

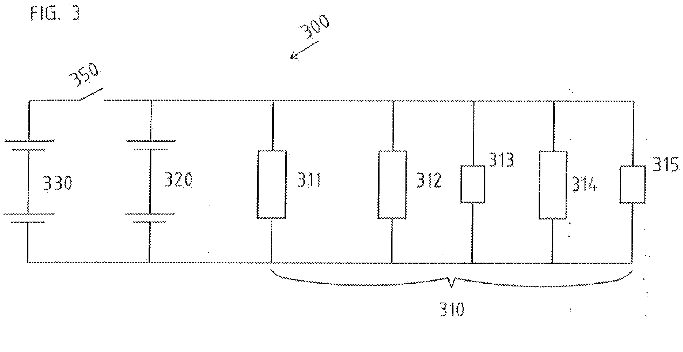

Figure 3 schematically shows a dual battery system 300, in which at least one power battery 320 is connected to an electrical system 310. The electrical system includes a starter motor 313 and battery charging means, including a generator 314. As stated above, the electrical system also includes electrical devices being used when the motor is not running, such as driver compartment heating 312, lights 311 and the like.

Also, the electrical system 310 includes an EMS 315 controlling the starter motor 313. In the dual battery system 300, at least one starter battery 330 is connectable in parallel with the at least one power battery 320 by the use of a dual circuit breaker 350. Thus, when the dual circuit breaker 350 is closed, the at least one starter battery 330 and the at least one power battery 320 are coupled in parallel and together provide a dual system voltage to the electrical system 310. When the dual circuit breaker 350 is open, the at least one power battery 320 alone provides electric power to the electrical system. Thus, the dual circuit breaker 350 is used to control the electrical power being provided to the electrical system, such that extra power can be provided from the at least starter battery 330 when the starter motor 313 is to be activated.

In the dual battery system 300, the at least one power battery 320 is essentially only used for providing power to the electrical devices in the electrical system 310, which are used when the motor is not running. Therefore, the at least one power battery 320 can be optimised regarding cycling capacity. Correspondingly, the at least one starter battery 330 is essentially only used for providing power to the starter motor 313, and can thus be optimised in regard of starting power characteristics. Thus, a more optimised battery system can be achieved.

Also, when charging the at least one power battery 320 and the at least one starter battery 330, the dual circuit breaker 350 can be used for connecting and/or disconnecting the starter battery 330 to the charging means, where the charging means includes the generator 314.

The prior art battery systems have a general problem related to sub-optimised charging of its batteries, which shortens a length of a useful life of the batteries, which has economical and environmental disadvantages. In particular, overcharging of the at least one starter battery, leading to corrosion and loss of water for the at least one starter battery, which results from inferior prior art charging methods, reduces the length of the useful life of the at least one starter battery. EP0753925 shows a dual battery system and a method for controlling such a system.

### Aim and most important features of the invention

It is an object of the present invention to provide a method for determining a resulting charging duration, a computer program, and an arrangement for determining a resulting charging duration that solve the above stated problem.

Thus, the present invention aims to provide a method for determining a resulting charging duration to be used when charging the at least one starter battery in a dual battery system, which results in a prolonged, or at least not in an unnecessarily shortened, useful life of the at least one starter battery.

The object is achieved by a method for determining a resulting charging duration to be used for charging at least one starter battery in a dual battery system according to the characterizing portion of claim 1.

The object is also achieved by an arrangement arranged for determining a resulting charging duration to be used for charging at least one starter battery in a dual battery system according to the characterizing portion of claim 17.

The object is also achieved by a computer program implementing the method of the present invention.

The method, arrangement and computer program for determining a resulting charging duration according to the present invention are characterized in that an initial charging duration is first determined based on a temperature of the starter battery and on a measure of the behaviour of the starter motor, when being activated. Then, a resulting charging duration to be used for charging the at least one starter battery is determined adaptively based on the initial charging duration and on a relation between a nominal charging voltage and an actual charging voltage being used for charging the at least one starter battery. The determination of the resulting charging duration is performed during charging of the at least one starter battery. Thus, the resulting charging duration time is adaptively adjusted based on the quality of the actual charging being performed, which results in a very efficient and exact determination of the resulting charging duration. The determination of the resulting charging duration is here adaptively based on both the temperature of the at least one starter battery and on the actual charging voltage being used for charging the at least one starter battery, which both are parameters being essential for the efficiency of the charging being performed.

By using the exactly determined resulting charging duration when charging the at least one starter battery, overcharging of the at least one starter battery is avoided, which has the result that the useful life of the at least one starter battery is not unnecessarily shortened due to corrosion and loss of water. The batteries can therefore be used longer, which has both economical and environmental advantages.

According to an embodiment of the present invention, the resulting charging duration is determined by first setting a remaining charging duration equal to the initial charging duration and then performing one or more reductions on the remaining charging duration. Each reduction is here related to a difference between the actually used charging voltage, and the nominal charging voltage, wherein the reduction has a relatively higher value if the difference is small, and has a relatively lower value if the difference is large. The resulting charging duration here corresponds to the time duration which is needed for the at least one reduction to reduce the remaining charging duration to zero time units

This embodiment has the advantage that the adaption of the resulting charging duration, i.e. the at least one reduction of the remaining charging duration, is closely related to the actually used charging voltage, which results in a very exact adaption. Also, this embodiment has advantages being related to the implementation of the method, since the adaption can be achieved by an iterative loop, which is easily implemented when programming instructions for a processing means executing the method.

Detailed exemplary embodiments and advantages of the method for determining a resulting charging duration, the computer program, and the arrangement for determining a resulting charging duration according to the invention will now be described with reference to the appended drawings illustrating some preferred embodiments.

### Brief description of the drawings

Fig. 1 schematically shows a traditional battery system.
Fig. 2 schematically shows a prior art battery system.
Fig. 3 schematically shows a dual battery system.
Fig. 4 shows a flowchart for a general method according to the present invention.
Fig. 5 shows a flowchart for a method according to the present invention.
Fig. 6 shows a flowchart illustration of a possible implementation of a method of the present invention.
Fig. 7a schematically shows an arrangement for determining a charging duration according to the present invention.
Fig. 7b schematically shows a system arranged for charging according to the present invention.

### Detailed description of preferred embodiments

When charging batteries, the resulting charging duration, i.e. the time actually being used for charging the batteries, and the charging voltage used are essential for not degrading the capacity and shortening the useful life of the batteries. Generally, when the resulting charging duration for a battery is too short, an irreversible sulphate crystal growth gradually increases until the battery is sulphated. On the other hand, when the resulting charging duration time is too long, corrosion and loss of water occurs in the battery, which also shortens its useful life.

Hereafter, the methods and arrangements for determining a resulting charging duration and for performing the charging of the at least one starter battery are exemplified for a vehicle. However, as is clear for a skilled person, corresponding methods and arrangements may also be used in vessels, or in other arrangements where a dual battery system can be used.

In this document, an initial charging duration and a remaining charging duration are values being used by the methods and arrangements of the invention in the process of determining the time period the charging of the one or more starter batteries should be performed. The initial charging duration corresponds to a time period, which initially, i.e. relatively soon after the starter motor has been activated, is believed to be sufficient for charging the one or more starter batteries. During charging of the one or more starter batteries, it is estimated that the charging has to be continued for a time period corresponding to the remaining charging duration. The remaining charging duration is utilized, during the process of charging the one or more starter batteries, by the method and apparatus of the invention for determining a resulting charging duration. Charging of the at least one starter battery will be performed for a time period being equal to the resulting charging duration. For example, according to an embodiment of the invention disclosed below, the remaining charging duration is first set equal to the initial charging duration. Then, the remaining charging duration is reduced once or more until zero time units is left of the remaining charging duration. The resulting charging duration then corresponds to the time period from setting the initial charging duration, i.e. from a time instant relatively soon after the starter motor was activated, until the time instant when zero time units is left of the remaining charging duration.

In the dual system schematically illustrated in figure 3, the at least one starter battery 330 essentially only provides DC current to the electrical system 310 when it drives the starter motor 313, while the at least one power battery 320 is used for providing essentially all other DC current being consumed by the electrical system 310. Thus, usually, when charging of the batteries is to be performed, the at least one starter battery 330 and the at least one power battery 320 are not equally run down. Therefore, when charging the at least one starter battery 330 and the at least one power battery 320, differing charging durations are usually needed for the at least one starter battery 330 and the at least one power battery 320.

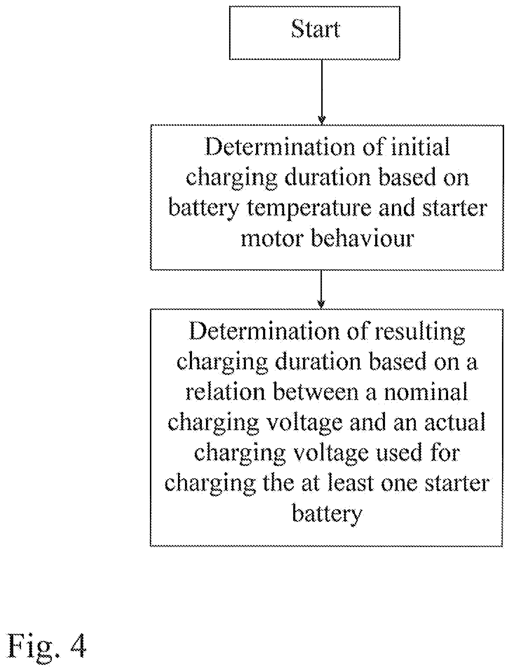

Figure 4 shows a flowchart for a general method according to the present invention for determining a resulting charging duration to be used when charging at least one starter battery 330 in a dual battery system. In a first step of the method according to the invention, an initial charging duration is determined. The determination of the initial charging duration takes into account the temperature of the at least one starter battery 330 and also a measure of the behaviour of the starter motor 313, when it is activated. The starter motor is activated by at least one of the starter battery 330 and the power battery 320.

In a second step of the method, a resulting charging duration to be used for charging the at least one starter battery 330 is determined. The resulting charging duration is determined based on the initial charging duration being determined in the first step of the method, and on a relation between a nominal charging voltage and an actual charging voltage being used for charging said at least one starter battery. The second step is performed during the time used for charging of the at least one starter battery 330.

Thus, according to the method of the present invention, the resulting charging duration for charging the at least one starter battery 330 is adaptively determined, i.e. the initial charging duration is first determined, followed by adaptive determination of the resulting charging duration. In practice, a remaining charging duration is first set equal to the initial charging duration, and then consecutive reductions of the remaining charging duration are adaptively performed. The resulting charging duration corresponds to the time which is needed for these reductions to reduce the remaining charging duration to zero time units.

When the initial charging duration is determined, a temperature of the at least one starter battery 330 and a behaviour of the starter motor 313 when it is activated are taken into account for determining the initial charge duration time. According to an embodiment of the present invention, the initial charging duration should be longer than a predefined shortest charging duration time (a minimum charging duration) and should be shorter than a predefined longest charging duration time (a maximal charging duration). The shortest and longest charging duration times are both chosen to values being dependent on the temperature of the at least one starter battery 330.

According to an embodiment of the present invention, the temperature of the at least one starter battery 330 is determined by measuring the temperature. This can be done in a number of ways, as is clear for a skilled person, e.g. by using temperature sensors providing temperature related signals. According to another embodiment of the present invention, the temperature is estimated, where the estimation is based on a battery model used for the at least one starter battery 330.

According to an embodiment of the invention, the behaviour of said starter motor 313, which is used for determining the initial charging duration, is determined in relation to the measured or estimated temperature of the at least one starter battery 330 , such that a temperature relative behaviour, i.e. a temperature relative starting performance, is determined. The temperature relative starting behaviour is determined by analysing the cranking performed by the starter motor 313. According to an embodiment of the invention, the starting behaviour is based on a rotation speed measure of the starter motor 313 during start, e.g. a measure of an average rotation speed, and on a time during which cranking is performed. Thus, a speed of the cranking and a time used for that cranking when running the starter motor 313 are used to determine if it was easy or hard to start the motor, i.e. to determine the behaviour of the starter motor 313. This behaviour is then related to the temperature of the at least one starter battery 330.

When determining the resulting charging duration to be used for charging the at least one starter battery 330, the remaining charging duration is first set equal to the initial charging duration, and the remaining charging duration is then reduced during charging of the at least one starter battery 330, thereby achieving an adaptive determination of the resulting charging duration. The performed reduction is based on a relation between a nominal charging voltage and an actual charging voltage being used for charging the at least one starter battery 330.

According to an embodiment of the present invention, the nominal charging voltage is related to the temperature of the at least one starter battery 330. In order to determine the nominal charging voltage, the temperature of the at least one starter battery 330 is, as described above, either measured or estimated, and then the nominal charging voltage is determined based on this temperature. Basically, there are for commonly used batteries a well defined and known relation between nominal charging voltage and temperature, which can be utilized for determining the nominal charging voltage for the at least one starter battery 330 according to the invention.

According to an embodiment of the present invention, the actual charging voltage being used for charging the at least one starter battery 330 is determined by measuring the actual voltage being provided by the charging means, including the generator 314. This actually provided charging voltage can be measured using means normally being present in e.g. a vehicle for controlling the function of the charging means.

As was stated above, according to the method of invention, the resulting charging duration to be used for charging the at least one starter battery 330 is adaptively determined by, during charging of the at least one starter battery 330, adaptively reducing the remaining charging duration. According to an embodiment of the invention, the size of the reduction depends on a relation between the nominal charging voltage and the actual charging voltage being used for charging the at least one starter battery 330.

According to an embodiment of the present invention, the reduction of the remaining charging duration has a relatively high value if the difference between the voltage levels of the nominal charging voltage and actual charging voltage is relatively small. This large reduction can be made, since when the starter battery 330 is charged by an actual charging voltage being close to a nominal charging voltage for the temperature of the at least one starter battery 330, an optimal or near-optimal charging of the at least one starter battery 330 is performed. Thus, it can then be concluded that the at least one starter battery 330 has been efficiently charged, and the resulting charging duration can be made relatively short.

On the other hand, if the difference between the voltage levels of the nominal charging voltage and the actual charging voltage is relatively large, i.e. when the at least one starter battery 330 is charged by an actual charging voltage being relatively much lower than the nominal charging voltage, the reduction of the remaining charging duration has a relatively low value. Thus, since the charging of the at least one starter battery 330 has been performed in a non-optimal manner, the reduction of the remaining charging duration time should be relatively small, which results in a relatively long resulting charging duration.

By the determination of the resulting charging duration time, by adaptive reductions of the remaining charging duration time, based on the quality of the actually performed charging of the at least one starter battery 330, a very exact time duration, i.e. the resulting charging duration, during which the at least one starter battery 330 should be charged, can be determined. Also, since this determination, according to an embodiment, is adaptively adjusted based on parameters being essential for the efficiency of the charging being performed, i.e. on both the temperature of the at least one starter battery 330 and on the actual charging voltage being used for charging the at least one starter battery 330, the resulting charging duration time can, by the present invention, be customised to the momentary conditions for both the at least one starter battery 330 and the charging means, including the generator 314.

Thereby, no overcharging of the at least one starter battery 330 is performed by mistake, which guaranties that the useful life of the at least one starter battery is not unnecessarily shortened due to corrosion and loss of water. Also, undercharging is avoided by the exactly determined resulting charging duration.

According to an embodiment of the present intention, the size of each such reduction of the remaining charging duration corresponds to a reduction time *tᵣ*, which is equal to an actual time *tₐ* having been spent on charging the at least one starter battery 330 since the preceding reduction multiplied by a constant *k, tᵣ* = *k^{∗}ta.* Thus, the actual time *tₐ* is here the normal time passing by between two consecutive reductions of the remaining charging duration. The constant *k* is here determined based on the difference between the actual charging voltage and the nominal charging voltage. That is, each reduction can be seen as causing the second-hand indicator of a clock timing the charging to run at a higher speed than the chronological time for the time from the preceding reduction to the current reduction, where the constant *k* determines how much faster it should run.

According to an embodiment of the invention, the value of the constant *k* is dependent on both the difference between the actual charging voltage and the nominal charging voltage, and on the temperature of the at least one starter battery.

According to an embodiment of the present invention, specific values for a relatively larger reduction are specified. Here the constant *k* has a value in the interval of approximately 3 to 6.5 if the difference between the actual charging voltage and the nominal charging voltage is approximately 0 % to 2 % of the nominal charging voltage. More specifically, the constant *k* has a value of approximately 6, *k* ≈ 6, if the difference is approximately 0 % of the nominal charging voltage, i.e. when approximately nominal charging voltage is used. Also, the constant *k* has a value of approximately 3.5, *k* ≈ 3.5, if the difference is approximately 2 % of the nominal charging voltage.

According to another embodiment of the present invention, specific values for a relatively smaller reduction are specified. Here, the constant *k* has a value in the interval of approximately 0.5 to 2.5 if the difference between the actual charging voltage and the nominal charging voltage is approximately 4 % to 10 % of the nominal charging voltage. More specifically, the constant *k* has a value of approximately 2, *k* ≈ 2, if the difference is approximately 4 % of the nominal charging voltage. Also, the constant k has
a value of approximately 1 , *k* ≈ 1, if the difference is approximately 10 % of the nominal charging voltage.

These specific values for the constant *k,* corresponding to larger and smaller reductions, respectively, guarantees a very exact resulting charging duration to be used when charging the at least one starter battery.

According to an embodiment of the present invention, the reductions of the remaining charging duration are also based on a predefined maximum charging duration, which can be determined based on the battery temperature of the one or more starter batteries. If the maximum charging duration has been reached at a specific point in time, i.e. if the at least one starter battery 330 has been charged for a total time exceeding the maximum charging duration, the reduction is such that the remaining charging duration is reduced to zero time units. Thus, when the maximum charging duration has been reached, the remaining charging duration should, when determining the reduction, be shortened such that zero time units is left of the remaining charging duration from that specific point in time, and the charging of the at least one starter battery 330 is ended.

According to an embodiment of the present invention, the reductions of the remaining charging duration are based on a predefined minimum charging duration, which also can be determined based on the battery temperature of the one or more starter batteries. If the minimum charging duration has not been reached in total at an instant of time, the adjustment is not allowed to be a reduction which reduces the remaining charging duration to a value such that zero time units is left of the remaining charging duration from that instant of time, i.e. the reduction reduces the remaining charging duration to a value corresponding to more than zero time units. Thus, the charging of the at least one starter battery 330 is not allowed to be ended before the at least one starter battery 330 has been charged at least for the minimum charging duration.

By restricting the adaptive adjustment of the resulting charging duration by the use of the minimum and maximum charging duration times, respectively, an extra precautionary measure against undercharging and overcharging, respectively, of the at least one starter battery 330 is achieved.

According to an embodiment of the present invention, the reduction is based on if the charging means, including the generator 314, provides a charging voltage or not. If the charging means does not provide a charging voltage, the reduction reduces the remaining charging duration to a value such that zero time units is left of the remaining charging duration from that point in time. Thus, when the generator stops generating a charging voltage, the attempted charging of the at least one starter battery should be ended.

According to an embodiment of the present invention, the reduction of the remaining charging duration includes at least two consecutive subtractions. Each of these subtractions is performed as a reduction described above. Thus, for an embodiment, for each subtraction, an actual charging voltage is determined and used together with the nominal charging voltage for determining the value for that subtraction. Alternatively, for another embodiment, both the actual charging voltage in relation to the nominal charging voltage, and the temperature of the at least one starter battery are used for determining the size of the subtraction.

Thus, an adaptive determination of the resulting charging duration used for charging the at least one starter battery here includes consecutive determinations of the differences between the voltage levels for the actual charging voltage and the nominal charging voltage and possibly also the starter battery temperature, wherein each consecutive determination possibly being followed by a reduction of the remaining charging duration, where the reduction is related to the result of that determination. This assures a very exact determination of the resulting charging duration time being used for charging the at least one starter battery 330, also when the temperature of the at least one starter battery and/or the level of the actual charging voltage varies over time.

These consecutive reductions of the remaining charging duration can be performed essentially at any time interval guaranteeing that the resulting charging duration time can be properly adapted to the variations in temperature of the at least one starter battery 330 and/or the level of the actual charging voltage. According to an embodiment of the present invention, two consecutive reductions are separated in time by approximately 0.5 seconds to approximately 3 minutes, and are preferably separated in time by approximately 1 second to approximately 1 minute, and are more preferably separated in timed by approximately 1 second to approximately 30 seconds, and are even more preferably separated in time by approximately 1 second to approximately 15 seconds.

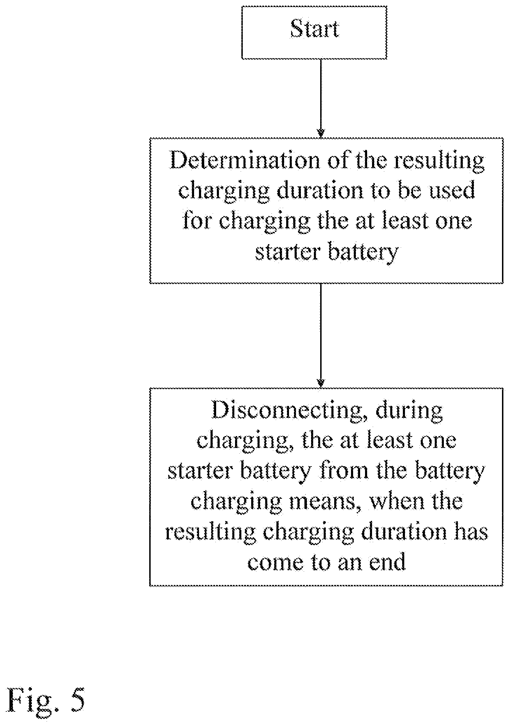

Further, according to an embodiment of the invention, the method for determining a resulting charging duration for the at least one starter battery 330 is utilised in a general method for charging at least one starter battery 330 in a dual battery system. This method is illustrated by the flow chart diagram of figure 5. In a first step of the method for charging the at least one starter battery 330, the resulting charging duration to be used for charging the at least one starter battery 330 is determined according to anyone of the methods described above. In a second step of the method, the determined resulting charging duration is utilized as the at least one starter battery 330 is disconnected from the battery charging means 314 when the remaining charging duration equals to zero time units, i.e. when the resulting charging duration has come to an end. Thus, overcharging of the at least one starter battery 330 is prevented by use of the charging method of the present invention, since charging is ended when the adaptively determined resulting charging duration is zero time units.

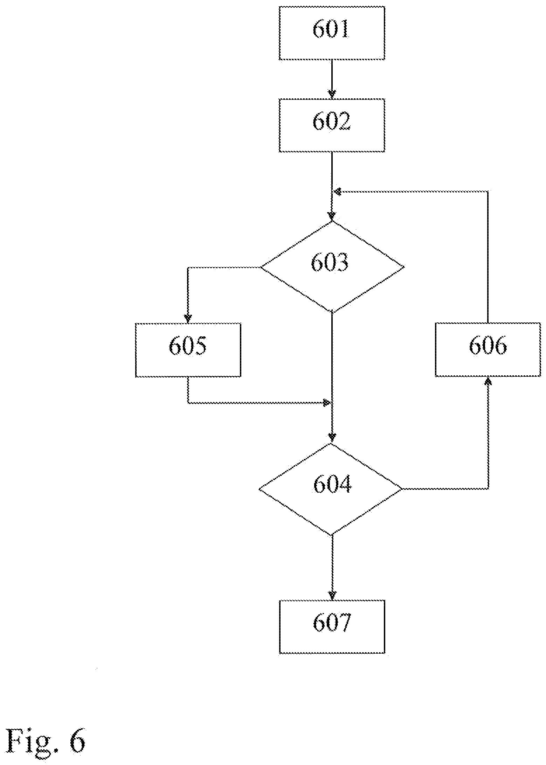

A practical implementation of the method of the present invention for charging the at least one starter battery 330 can be realised in a number of different ways. One such way is exemplified in the following in connection with the flow sheet diagram in figure 6.

In a first method step 601 of this embodiment of the present invention the initial charging duration for the at least one starter battery 330 is determined as stated above, i.e. based on the temperature of the at least one starter battery 330 and the behaviour of the starter motor 313. A remaining charging duration is then set to be equal to the initial charging duration. In a second step of the method 602, charging of the at least one starter battery 330 is started. Thus, the at least one starter battery 330 is here connected to the battery charging means 314, i.e. the dual circuit breaker 350 is closed.

In a third step 603, a relation between a nominal charging voltage and an actual charging voltage is determined, where the actual charging voltage is the voltage actually being used for charging the at least one starter battery. For example, in the third step 603, the actual charging voltage is compared to the nominal charging voltage, and then the difference between these voltages is analysed. If the difference is relatively large, the method continues to the fourth step 604.

In the fourth step 604, it is determined how much of the remaining charging duration is left. If the remaining charging duration is longer than zero time units, such as hours, minutes or seconds, the method continues to the sixth step 606. If the remaining charging duration is not longer than zero time units, the method continues to the seventh step 607.

In the sixth step 606, the remaining charging duration is reduced by a certain number of time units, such as a certain number of minutes. From the sixth step 606, the method continues back to the third step 603, i.e. an iterative process is used for reducing the remaining charging duration, such that an adaptive determination of the resulting charging duration is performed.

In the third step 603, if the difference between the nominal and actual voltages is instead relatively small, the method first continues to the fifth step 605 and then continues to the fourth step 604. In the fifth step 605, the remaining charging duration is reduced by a certain number of time units, such as a certain number of minutes. From the fifth step 605, the method continues to the fourth step 604. In the fourth step 604 it is, as stated above, checked whether there is time left of the remaining charging duration. If there is time left, the method continues to the sixth step 606, and if not, the method continues to the seventh step 607.

In the seventh step 607, the charging of the at least one starter battery 330 is ended. According to one embodiment of the invention, this is achieved by instructing the dual circuit breaker 350 to break the dual system circuit, i.e. to disconnect the at least one starter battery 330 from the battery charging means 314.

Thus, by the iterative implementation of the method of the present invention, the remaining charging duration is reduced quicker if the difference between the nominal and actual charging voltages is relatively small, i.e. when a near-optimum actual charging voltage is used for charging the at least one starter battery, than if the difference is relatively large. In other words, the reduction time *tᵣ* to be subtracted from the remaining charging duration after such a determination is equal to an actual time *tₐ* being spent on charging the at least one starter battery since the preceding reduction multiplied by a constant *k, tᵣ* = *k^{∗}ta,* wherein the constant *k* has a higher value if the difference between the actual charging voltage and the nominal charging voltage is small, than if the difference is big. Also, according to an embodiment, the size of the constant *k* is dependent on the both this difference and on the temperature of the starter battery.

According to an implementation of one embodiment of the invention, it is also checked in step 604 if a minimum charging duration has been reached and/or if a maximum charging duration has been exceeded. If the minimum charging duration has not been reached yet, the method continues to the sixth step 606. However, if the maximum charging duration has been exceeded, the method reduces the remaining charging duration to zero time units by subtracting a sufficient amount of time units, and then continues to the seventh step 607.

According to an implementation of one embodiment of the invention, if the actual charging voltage is equal to or close to zero, i.e. if the battery charging means has stopped providing a charging voltage, the method reduces the remaining charging duration to zero time units by subtracting a sufficient amount of time units, and then continues to the seventh step 607.

As is clear for a skilled person, the details of the implementation of the iterative process described above can be varied. For example, the iterative adaption can be performed in a number of ways. Thus, the reduction of the remaining charging duration being performed iteratively can also be performed e.g. by letting the method after the third step 603 continue to either one of a first and a second reductions steps before continuing to the fourth step 604, where each of the first and second reduction steps then would perform a specific reduction of the remaining charging duration, and where the specific reductions being performed by each of the first and second reduction step is different from the other, i.e. the first and second reduction step having differing constants *k.* The choice of selecting either of the first and second reduction steps would here be based on the difference between the nominal and actual voltages, and possibly on the temperature of the starter battery, as determined in the fourth step 604.

Further, the method of the invention can be implemented in a computer program, having code means, which when run in a computer causes the computer to execute the steps of the method. The computer program is included in a computer readable medium of a computer program product. The computer readable medium may consist of essentially any memory, such as a ROM (Read-Only Memory), a PROM (Programmable Read-Only Memory), an EPROM (Erasable PROM), a Flash memory, an EEPROM (Electrically Erasable PROM), or a hard disk drive.

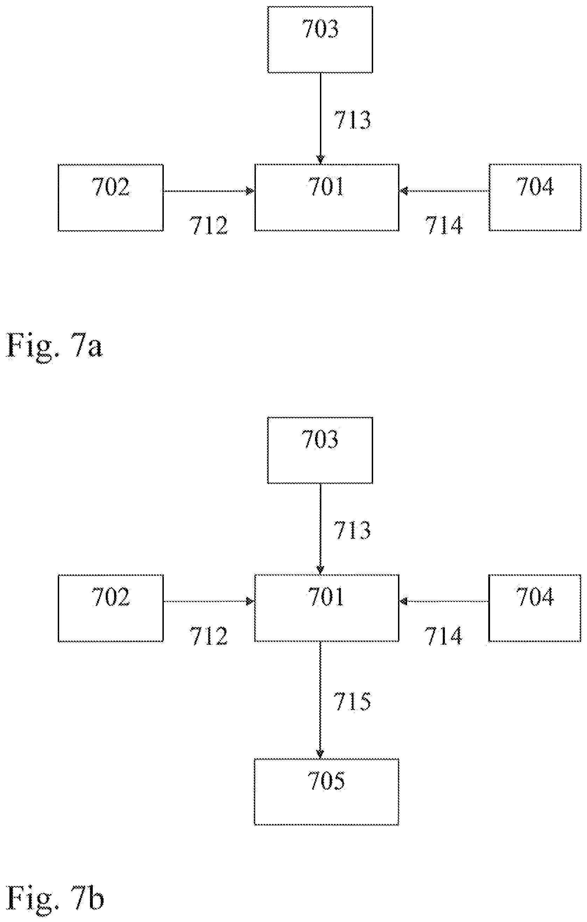

Figure 7a shows an arrangement for determining a resulting charging duration for at least one starter battery in a dual battery system according to the present invention, including a processing means 701, such as a computer, a starter battery temperature determining means 702, an actual charging voltage determining means 703, and a starter motor behaviour determining means 704.

The starter battery temperature determining means 702 can be essentially any kind of sensor or the like being able to determine the temperature of the starter battery, such as battery temperature sensors being used also for other purposes in the vehicle, or a battery temperature sensor being specially adapted for this arrangement. The starter battery temperature determining means 702 is connected to the processing means 701 by connection means 712.

The actual charging voltage determining means 703 can be essentially any means, which is configured to determine the charging voltage output from the battery charging means, i.e. the charging voltage being provided to the at least one starter battery for charging it. This actual charging voltage determining means 703 can also be used by other systems in the vehicle, such as generator failure warning systems. The actual charging voltage determining means 703 is connected to the processing means 701 by connection means 713.

The starter motor behaviour determining means 704 estimates how easy or hard it was to start the motor, by utilising, according to an embodiment of the invention, the time used for cranking and the speed of the cranking to determine the behaviour of the starter motor when being activated. Also other parameters can be used for determining the behaviour of the starter motor as is clear for a skilled person. The starter motor behaviour determining means 704 is connected to the processing means 701 by connection means 714.

Figure 7b shows a system for charging at least one starter battery in a dual battery system. In the system shown in figure 7b, the whole arrangement for determining a resulting charging duration shown in figure 7a is included, having identical reference numerals as in figure 7a. Also, in the charging system, a dual circuit breaker activation means 705 is included. The dual circuit breaker activation means 705 is connected to the processing means by a connecting means 715. When the processing means has decided that the dual circuit breaker should be activated, a signal corresponding to this activation is provided to the dual circuit breaker activation means 705. The dual circuit breaker is then caused to close or open the dual circuit breaker, i.e. it connects or disconnects the starter battery to the battery charging means.

The connection means 712, 713, 714, 715 in figures 7a and 7b can each be either one in the group of a cable; a bus, such as a Controller Area Network (CAN) bus, a Media Orientated Systems Transport (MOST) bus, or the like, or a wireless connection. The processing means can be located in connection with the driver compartment or can be located in essentially any other part of the vehicle.

The methods for determining a charging duration and for charging as well as the arrangements for determining a charging duration and for performing a charging according to the invention may be modified by those skilled in the art, as compared to the exemplary embodiments described above.

## Claims

1. Method for determining a resulting charging duration, the time actually being used for charging the batteries, to be used for charging at least one starter battery (330) in a dual battery system, said dual battery system comprising:
- at least one power battery (320) being connected to an electrical system comprising a starter motor (313) and battery charging means, and
- said at least one starter battery (330), being connectable in parallel with said at least one power battery (320),
**characterized by** the steps of:
- determining an initial charging duration, the time period which initially is believed to be sufficient for charging the one or more starter batteries, based on a temperature of said at least one starter battery (330) and on a measure of a behaviour of a starter motor (313), when said starter motor (313) is activated, and
- determining, during charging of said at least one starter battery (330), said resulting charging duration based on said initial charging duration and on a relation between a nominal charging voltage and an actual charging voltage being used for charging said at least one starter battery (330), wherein said resulting charging duration is determined by:
- first setting a remaining charging duration to a value being equal to said initial charging duration, and
- performing, during a time corresponding to said resulting charging duration, at least one reduction of said remaining charging duration until zero time units remains of said remaining charging duration, wherein each one of said at least one reduction is related to a difference between said actual charging voltage and said nominal charging voltage, such that the reduction has a relatively higher value if said difference is relatively small, and such that said reduction has a relatively lower value if said difference is relatively large.

2. Method as claimed in claim 1, wherein the determination of said resulting charging duration is based also on a temperature of said at least one starter battery (330).

3. Method as claimed in claim 1 , wherein the reduction corresponds to a reduction time *tᵣ* being equal to an actual time *tₐ* being spent on charging said at least one starter battery (330) since a preceding reduction multiplied by a constant *k, tᵣ* = *k^{∗}ta,* wherein said constant *k* is determined based on said difference between said actual charging voltage and said nominal charging voltage.

4. Method as claimed in claim 3 , wherein said constant *k* has any value in the group of:
- a value of approximately 3 to 6.5 if said difference is approximately 0 % to 2 % of said nominal charging voltage; and
- a value of approximately 0.5 to 2.5 if said difference is approximately 4 % to 10 % of said nominal charging voltage.

5. Method as claimed in claim 4 , wherein said constant k has any value in the group of:
- a value of approximately 6, k ≈ 6, if said difference is approximately 0 % of said nominal charging voltage;
- a value of approximately 3.5, k ≈ 3.5, if said difference is approximately 2 % of said nominal charging voltage,
- a value of approximately 2, k ≈ 2, if said difference is approximately 4 % of said nominal charging voltage; and
- a value of approximately 1 , k ≈ 1, if said difference is approximately 10 % of said nominal charging voltage.

6. Method as claimed in anyone of claims 1 to 5 , wherein at least two reductions of said remaining charging duration are performed, wherein, for each reduction, an actual charging voltage is determined and used for determining the size of the reduction.

7. Method as claimed in claim 6 , wherein two of said consecutive reductions are separated in time by approximately 0.5 second to 3 minutes, preferably approximately 1 second to 1 minute, more preferably approximately 1 second to 30 seconds, even more preferably approximately 1 second to 15 seconds.

8. Method as claimed in anyone of claims 1-7, wherein
- a maximum charging duration is determined based on a battery temperature for said at least one starter battery (330), and
- the reduction is based on said maximum charging duration, such that, if said maximum charging duration is reached at an instant of time, said reduction reduces said remaining charging duration to a value corresponding to zero time units.

9. Method as claimed in anyone of claims 1-7, wherein
- a minimum charging duration is determined based on a battery temperature for said at least one starter battery (330), and
- the reduction is based on said minimum charging duration, such that, if said minimum charging duration has not been reached in total at an instant of time, said reduction reduces said remaining charging duration to a value corresponding to more than zero time units.

10. Method as claimed in anyone of claims 1-9 , wherein said nominal charging voltage is determined based on a battery temperature of said at least one starter battery (330).

11. Method as claimed in anyone of claims 1-10 , wherein said measure of said behaviour of said starter motor (313) is determined in relation to said temperature of said at least one starter battery (330).

12. Method as claimed in claim 11 , wherein said behaviour is determined based on a cranking being performed by said starter motor (313), wherein a rotation speed of said cranking and a time used for said cranking are taken into account.

13. Method as claimed in any one of claims 1-12 , wherein said temperature of said at least one starter battery (330) is determined by measuring said temperature, or by estimating said temperature based on a battery model.

14. Method for charging at least one starter battery (330) in a dual battery system, said dual battery system comprising:
- at least one power battery (320) being connected to an electrical system comprising a starter motor (313) and battery charging means, and
- said at least one starter battery (330), being connectable in parallel with said at least one power battery (320) by a dual circuit breaker,
**characterized by** the steps of:
- determining a resulting charging duration to be used for charging said at least one starter battery (330) by using the method claimed in anyone of claims 1-13, and
- disconnecting, during charging of said at least one starter battery (330), said at least one starter battery (330) from said battery charging means when said resulting charging duration has come to an end.

15. Computer program, **characterised in** code means, which when run in a computer causes the computer to execute the method according to any of the claims 1-14.

16. Computer program product including a computer readable medium and a computer program according to claim 15, wherein said computer program is included in the computer readable medium.

17. An arrangement for determining a resulting charging duration, the time actually being used for charging the batteries, to be used for charging at least one starter battery (330) in a dual battery system, said dual battery system comprising:
- at least one power battery being (320) connected to an electrical system comprising a starter motor (313) and battery charging means, and
- said at least one starter battery (330), being connectable in parallel with said at least one power battery (320),
**characterized by:**
- means for determining an initial charging duration, the time period which initially is believed to be sufficient for charging the one or more starter batteries, based on a temperature of said at least one starter battery (330) and on a measure of a behaviour of a starter motor (313), when said starter motor is activated,
- means for determining, during charging of said at least one starter battery (330), a resulting charging duration to be used for charging said at least one starter battery (330), wherein the determination is based on said initial charging duration and on a relation between a nominal charging voltage and an actual charging voltage being used for charging said at least one starter battery (330).

18. A system for charging at least one starter battery (330) in a dual battery system, said dual battery system comprising:
- at least one power battery (320) being connected to an electrical system comprising a starter motor (313) and battery charging means, and
- said at least one starter battery (330), being connectable in parallel with said at least one power battery (320) by a dual circuit breaker,
**characterized by:**
- the arrangement as claimed in claim 17 , and
- disconnecting means, arranged for disconnecting, during charging of said at least one starter battery (330), said at least one starter battery (330) from said battery charging means when said resulting charging duration has come to an end.

## Patentansprüche

1. Verfahren zum Bestimmen einer entstehenden Ladungsdauer, der Zeit, die tatsächlich für das Laden der Batterien aufgebracht wird, die zum Laden zumindest einer Anlasserbatterie (330) in einem Dualbatteriesystem aufgebracht wird, wobei das Dualbatteriesystem umfasst:
- zumindest eine Leistungsbatterie (320), die mit einem elektrischen System verbunden ist, das einen Anlassermotor (313) und ein Batterieladungsmittel umfasst, und
- die zumindest eine Anlasserbatterie (330), die mit der zumindest einen Leistungsbatterie (320) parallel schaltbar ist,
**gekennzeichnet durch** die Schritte:
- Bestimmen einer anfänglichen Ladungsdauer, der Zeitraum, der Erwartungen zufolge anfänglich zum Laden der einen oder mehreren Anlasserbatterien ausreichend ist, auf Basis einer Temperatur der zumindest einen Anlasserbatterie (330) und eines Messwerts für ein Verhalten eines Anlassermotors (313), wenn der Anlassermotor (313) aktiviert ist, und
- Bestimmen der entstehenden Ladungsdauer während des Ladens der zumindest einen Anlasserbatterie (330) auf Basis der anfänglichen Ladungsdauer und einer Beziehung zwischen einer Nennladungsspannung und einer tatsächlichen Ladungsspannung, die zum Laden der zumindest einen Anlasserbatterie (330) verwendet wird, wobei die entstehende Ladungsdauer bestimmt wird **durch**:
- vorläufiges Einstellen einer Restladungsdauer auf einen Wert gleich der anfänglichen Ladungsdauer, und
- Durchführen zumindest einer Verringerung der Restladungsdauer während einer Zeit, die der entstehenden Ladungsdauer entspricht, bis null Zeiteinheiten der Restladungsdauer übrig sind, wobei jede der zumindest einen Verringerung mit einem Unterschied zwischen der tatsächlichen Ladungsspannung und der Nennladungsspannung in Zusammenhang steht, so dass die Verringerung einen relativ höheren Wert aufweist, wenn der Unterschied relativ klein ist, und so dass die Verringerung einen relativ geringeren Wert aufweist, wenn der Unterschied relativ groß ist.

2. Verfahren nach Anspruch 1, wobei das Bestimmen der entstehenden Ladungsdauer auch auf einer Temperatur der zumindest einen Anlasserbatterie (330) basiert.

3. Verfahren nach Anspruch 1, wobei die Verringerung einer Verringerungszeit *tᵣ* entspricht, die gleich einer tatsächlichen Zeit *tₐ,* die für das Laden der zumindest einen Anlasserbatterie (330) aufgebraucht wird, seit einer vorangegangenen Verringerung multipliziert mit einer Konstante *k, tr* = *k ^{∗} tₐ*, ist, wobei die Konstante *k* auf Basis des Unterschieds zwischen der tatsächlichen Ladungsspannung und der Nennladungsspannung bestimmt wird.

4. Verfahren nach Anspruch 3, wobei die Konstante *k* einen beliebigen Wert aus der Gruppe aufweist von:
- einem Wert von ungefähr 3 bis 6,5, wenn der Unterschied ungefähr 0 % bis 2 % der Nennladungsspannung beträgt; und
- einem Wert von ungefähr 0,5 bis 2,5, wenn der Unterschied ungefähr 4 % bis 10 % der Nennladungsspannung beträgt.

5. Verfahren nach Anspruch 4, wobei die Konstante k einen beliebigen Wert aus der Gruppe aufweist von:
- einem Wert von ungefähr 6, k ≈ 6, wenn der Unterschied ungefähr 0 % der Nennladungsspannung beträgt;
- einem Wert von ungefähr 3,5, k ≈ 3,5, wenn der Unterschied ungefähr 2 % der Nennladungsspannung beträgt,
- einem Wert von ungefähr 2, k ≈ 2, wenn der Unterschied ungefähr 4 % der Nennladungsspannung beträgt; und
- einem Wert von ungefähr 1, k ≈ 1, wenn der Unterschied ungefähr 10 % der Nennladungsspannung beträgt.

6. Verfahren nach einem der Ansprüche 1 bis 5, wobei zumindest zwei Verringerungen der Restladungsdauer durchgeführt werden, wobei für jede Verringerung eine tatsächliche Ladungsspannung bestimmt und verwendet wird, um die Größe der Verringerung zu bestimmen.

7. Verfahren nach Anspruch 6, wobei zwei der aufeinanderfolgenden Verringerungen zeitlich um ungefähr 0,5 Sekunden bis 3 Minuten, vorzugsweise ungefähr 1 Sekunde bis 1 Minute, mehr bevorzugt ungefähr 1 Sekunde bis ungefähr 30 Sekunden, noch mehr bevorzugt ungefähr 1 Sekunde bis 15 Sekunden, getrennt sind.

8. Verfahren nach einem der Ansprüche 1 bis 7, wobei:
- eine Höchstladungsdauer auf Basis einer Batterietemperatur für die zumindest eine Anlasserbatterie (330) bestimmt wird, und
- die Verringerung auf der Höchstladungsdauer basiert, so dass, wenn die Höchstladungsdauer zu einem Zeitpunkt erreicht wird, die Verringerung die Restladungsdauer auf einen Wert verringert, der null Zeiteinheiten entspricht.

9. Verfahren nach einem der Ansprüche 1 bis 7, wobei:
- eine Mindestladungsdauer auf Basis einer Batterietemperatur für die zumindest eine Anlasserbatterie (330) bestimmt wird, und
- die Verringerung auf der Mindestladungsdauer basiert, so dass, wenn die Mindestladungsdauer zu einem Zeitpunkt nicht vollständig erreicht wurde, die Verringerung die Restladungsdauer auf einen Wert verringert, der mehr als null Zeiteinheiten entspricht.

10. Verfahren nach einem der Ansprüche 1 bis 9, wobei die Nennladungsspannung auf Basis einer Batterietemperatur der zumindest einen Anlasserbatterie (330) bestimmt wird.

11. Verfahren nach einem der Ansprüche 1 bis 10, wobei der Messwert für das Verhalten des Anlassermotors (313) in Bezug auf die Temperatur der zumindest einen Anlasserbatterie (330) bestimmt wird.

12. Verfahren nach Anspruch 11, wobei das Verhalten auf Basis eines vom Anlassermotor (313) durchgeführten Anlassens bestimmt wird, wobei eine Drehzahl des Anlassens und eine für das Anlassen aufgebrachte Zeit berücksichtigt werden.

13. Verfahren nach einem der Ansprüche 1 bis 12, wobei die Temperatur der zumindest einen Anlasserbatterie (330) durch Messen der Temperatur oder durch Schätzen der Temperatur auf Basis eines Batteriemodells bestimmt wird.

14. Verfahren zum Laden zumindest einer Anlasserbatterie (330) in einem Dualbatteriesystem, wobei das Dualbatteriesystem umfasst:
- zumindest eine Leistungsbatterie (320), die mit einem elektrischen System verbunden ist, das einen Anlassermotor (313) und ein Batterieladungsmittel umfasst, und
- die zumindest eine Anlasserbatterie (330), die durch einen Dualtrennschalter mit der zumindest einen Leistungsbatterie (320) parallel schaltbar ist,
**gekennzeichnet durch** die Schritte:
- Bestimmen einer entstehenden Ladungsdauer, die für das Laden der zumindest einen Anlasserbatterie (330) aufzubringen ist, unter Verwendung des Verfahrens nach einem der Ansprüche 1 bis 13, und
- Trennen der zumindest einen Anlasserbatterie (330) während des Ladens der zumindest einen Anlasserbatterie (330) vom Batterielademittel, wenn die entstehende Ladungsdauer zu Ende ist.

15. Computerprogramm, **gekennzeichnet durch** ein Codemittel, das bei Ausführung auf einem Computer den Computer dazu veranlasst, das Verfahren nach einem der Ansprüche 1 bis 14 durchzuführen.

16. Computerprogrammprodukt, das ein computerlesbares Medium und ein Computerprogramm nach Anspruch 15 enthält, wobei das Computerprogramm im computerlesbaren Medium enthalten ist.

17. Anordnung zum Bestimmen einer entstehenden Ladungsdauer, der Zeit, die tatsächlich für das Laden der Batterien aufgebracht wird, die zum Laden zumindest einer Anlasserbatterie (330) in einem Dualbatteriesystem aufgebracht wird, wobei das Dualbatteriesystem umfasst:
- zumindest eine Leistungsbatterie (320), die mit einem elektrischen System verbunden ist, das einen Anlassermotor (313) und ein Batterieladungsmittel umfasst, und
- die zumindest eine Anlasserbatterie (330), die mit der zumindest einen Leistungsbatterie (320) parallel schaltbar ist,
**gekennzeichnet durch:**
- ein Mittel zum Bestimmen einer anfänglichen Ladungsdauer, der Zeitraum, der Erwartungen zufolge anfänglich zum Laden der einen oder mehreren Anlasserbatterien ausreichend ist, auf Basis einer Temperatur der zumindest einen Anlasserbatterie (330) und eines Messwerts für ein Verhalten eines Anlassermotors (313), wenn der Anlassermotor aktiviert ist,
- ein Mittel zum Bestimmen einer entstehenden Ladungsdauer während des Ladens der zumindest einen Anlasserbatterie (330), die zum Laden der zumindest einen Anlasserbatterie (330) aufzubringen ist, auf Basis der anfänglichen Ladungsdauer und einer Beziehung zwischen einer Nennladungsspannung und einer tatsächlichen Ladungsspannung, die zum Laden der zumindest einen Anlasserbatterie (330) verwendet wird.

18. System zum Laden zumindest einer Anlasserbatterie (330) in einem Dualbatteriesystem, wobei das Dualbatteriesystem umfasst:
- zumindest eine Leistungsbatterie (320), die mit einem elektrischen System verbunden ist, das einen Anlassermotor (313) und ein Batterieladungsmittel umfasst, und
- die zumindest eine Anlasserbatterie (330), die durch einen Dualtrennschalter mit der zumindest einen Leistungsbatterie (320) parallel schaltbar ist,
**gekennzeichnet durch:**
- die Anordnung nach Anspruch 17, und:
- ein Trennmittel, das so ausgelegt ist, dass es die zumindest eine Anlasserbatterie (330) während des Ladens der zumindest einen Anlasserbatterie (330) vom Batterielademittel trennt, wenn die entstehende Ladungsdauer zu Ende ist.

## Revendications

1. Procédé pour la détermination d'un résultat de durée de charge, le temps étant effectivement utilisé pour la charge des batteries, à utiliser pour la charge d'au moins une batterie de démarrage (330) dans un système à batterie double, ledit système à batterie double comprenant :
- au moins une batterie d'alimentation (320) étant connectée à un système électrique comprenant un moteur de démarrage (313) et des moyens de charge de batterie, et
- ladite au moins une batterie de démarrage (330), pouvant être connectée en parallèle à ladite au moins une batterie d'alimentation (320),
**caractérisé par** les étapes suivantes :
- la détermination d'une durée de charge initiale, la période de temps qui est au départ censée suffire pour la charge de l'une ou de plusieurs batteries de démarrage, sur base d'une température de ladite au moins une batterie de démarrage (330) et sur une mesure d'un comportement d'un moteur de démarrage (313), lorsque ledit moteur de démarrage (313) est activé, et
- la détermination, lors de la charge de ladite au moins une batterie de démarrage (330), dudit résultat de durée de charge sur base de ladite durée de charge initiale et sur une relation entre une tension de charge nominale et une tension de charge courante étant utilisée pour la charge de ladite au moins une batterie de démarrage (330), dans lequel ledit résultat de durée de charge est déterminé par :
- premièrement le réglage d'une durée de charge restante pour une valeur étant égale à ladite durée de charge initiale, et
- la réalisation, lors d'un temps correspondant audit résultat de durée de charge, d'au moins une réduction de ladite durée de charge restante jusqu'à l'unité de temps zéro reste de ladite durée de charge restante, dans lequel chacune parmi ladite au moins une réduction est liée à une différence entre ladite tension de charge courante et ladite tension de charge nominale, de sorte que la réduction a une valeur relativement élevée si ladite différence est relativement petite, et de sorte que ladite réduction a une valeur relativement faible si ladite différence est relativement grande.

2. Procédé selon la revendication 1, dans lequel la détermination dudit résultat de durée de charge se base également sur une température de ladite au moins une batterie de démarrage (330).

3. Procédé selon la revendication 1, dans lequel la réduction correspond à un temps de réduction *tᵣ* étant égal à un temps réel *ta* étant passé sur la charge de ladite au moins une batterie de démarrage (330) depuis une réduction précédente multipliée par une constante *k*, *tᵣ* = *k^{∗}ta,* dans lequel ladite constante *k* est déterminée sur base de ladite différence entre ladite tension de charge courante et ladite tension de charge nominale.

4. Procédé selon la revendication 3, dans lequel ladite constante *k* a une quelconque valeur dans le groupe suivant :
- une valeur d'approximativement 3 à 6,5 si ladite différence est approximativement 0 % à 2 % de ladite tension de charge nominale ; et
- une valeur d'approximativement 0,5 à 2,5 si ladite différence est approximativement 4 % à 10 % de ladite tension de charge nominale.

5. Procédé selon la revendication 4, dans lequel ladite constante k a une quelconque valeur dans le groupe suivant :
- une valeur d'approximativement 6, k ≈ 6, si ladite différence est approximativement 0 % de ladite tension de charge nominale ;
- une valeur d'approximativement 3,5, k ≈ 3,5, si ladite différence est approximativement 2 % de ladite tension de charge nominale,
- une valeur d'approximativement 2, k ≈ 2, si ladite différence est approximativement 4 % de ladite tension de charge nominale ; et
- une valeur d'approximativement 1, k ≈ 1, si ladite différence est approximativement 10 % de ladite tension de charge nominale.

6. Procédé selon l'une quelconque des revendications 1 à 5, dans lequel au moins deux réductions de ladite durée de charge restante sont réalisées, dans lequel, pour chaque réduction, une tension de charge courante est déterminée et utilisée pour la détermination de la taille de la réduction.

7. Procédé selon la revendication 6, dans lequel deux desdites réductions consécutives sont séparées en temps par approximativement 0,5 seconde à 3 minutes, de préférence approximativement 1 seconde à 1 minute, plus de préférence approximativement 1 seconde à 30 secondes, encore plus de préférence approximativement 1 seconde à 15 secondes.

8. Procédé selon l'une quelconque des revendications 1-7, dans lequel
- une durée de charge maximale est déterminée sur base d'une température de batterie pour ladite au moins une batterie de démarrage (330), et
- la réduction se base sur ladite durée de charge maximale, de sorte que, si ladite durée de charge maximale est atteinte à un instant de temps, ladite réduction réduit ladite durée de charge restante à une valeur correspondant à unités de temps zéro.

9. Procédé selon l'une quelconque des revendications 1-7, dans lequel
- une durée de charge minimale est déterminée sur base d'une température de batterie pour ladite au moins une batterie de démarrage (330), et
- la réduction se base sur ladite durée de charge minimale, de sorte que, si ladite durée de charge minimale n'a pas été complètement atteinte à un instant de temps, ladite réduction réduit ladite durée de charge restante à une valeur correspondant à plus des unités de temps zéro.

10. Procédé selon l'une quelconque des revendications 1-9, dans lequel ladite tension de charge nominale est déterminée sur base d'une température de batterie de ladite au moins une batterie de démarrage (330).

11. Procédé selon l'une quelconque des revendications 1-10, dans lequel ladite mesure dudit comportement dudit moteur de démarrage (313) est déterminée en fonction de ladite température de ladite au moins une batterie de démarrage (330).

12. Procédé selon la revendication 11, dans lequel ledit comportement est déterminée sur base d'un démarrage étant réalisé par ledit moteur de démarrage (313), dans lequel une vitesse de rotation dudit démarrage et un temps utilisée pour ledit démarrage sont pris en compte.

13. Procédé selon l'une quelconque des revendications 1-12, dans lequel ladite température de ladite au moins une batterie de démarrage (330) est déterminée par la mesure de ladite température, ou grâce à l'estimation de ladite température sur base d'un modèle de batterie.

14. Procédé pour la charge d'au moins une batterie de démarrage (330) dans un système à batterie double, ledit système à batterie double comprenant :
- au moins une batterie d'alimentation (320) étant connectée à un système électrique comprenant un moteur de démarrage (313) et des moyens de charge de batterie, et
- ladite au moins une batterie de démarrage (330), pouvant être connectée en parallèle à ladite au moins une batterie d'alimentation (320) par un disjoncteur à double circuit, **Caractérisé par** les étapes suivantes :
- la détermination d'un résultat de durée de charge à utiliser pour la charge de ladite au moins une batterie de démarrage (330) en utilisant le procédé selon l'une quelconque des revendications 1-13, et
- la déconnexion, lors de la charge de ladite au moins une batterie de démarrage (330), de ladite au moins une batterie de démarrage (330) à partir desdits moyens de charge de batterie lorsque ledit résultat de durée de charge a pris fin.

15. **Programme informatique, caractérisé par** des moyens de code, qui, lorsqu'ils sont exécutés dans un ordinateur, amènent l'ordinateur à exécuter le procédé selon l'une quelconque des revendications 1-14.

16. Produit de programme informatique incluant un support lisible par ordinateur et un programme informatique selon la revendication 15, dans lequel ledit programme informatique est inclus dans le support lisible par ordinateur.

17. Agencement pour la détermination d'un résultat de durée de charge, le temps étant effectivement utilisé pour la charge des batteries, à utiliser pour la charge d'au moins une batterie de démarrage (330) dans un système à batterie double, ledit système à batterie double comprenant :
- au moins une batterie d'alimentation (320) étant connectée à un système électrique comprenant un moteur de démarrage (313) et des moyens de charge de batterie, et
- ladite au moins une batterie de démarrage (330), pouvant être connectée en parallèle à ladite au moins une batterie d'alimentation (320),
**caractérisé par :**
- des moyens pour la détermination d'une durée de charge initiale, la période de temps qui est au départ censée suffire pour la charge de l'une ou de plusieurs batteries de démarrage, sur base d'une température de ladite au moins une batterie de démarrage (330) et sur une mesure d'un comportement d'un moteur de démarrage (313), lorsque ledit moteur de démarrage est activé,
- des moyens pour la détermination, lors de la charge de ladite au moins une batterie de démarrage (330), d'un résultat de durée de charge à utiliser pour la charge de ladite au moins une batterie de démarrage (330), dans lequel la détermination se base sur ladite durée de charge initiale et sur une relation entre une tension de charge nominale et une tension de charge courante étant utilisée pour la charge de ladite au moins une batterie de démarrage (330).

18. Système pour la charge d'au moins une batterie de démarrage (330) dans un système à batterie double, ledit système à batterie double comprenant :
- au moins une batterie d'alimentation (320) étant connectée à un système électrique comprenant un moteur de démarrage (313) et des moyens de charge de batterie, et
- ladite au moins une batterie de démarrage (330), pouvant être connectée en parallèle à ladite au moins une batterie d'alimentation (320) par un disjoncteur à double circuit,
**caractérisé par** :
- Agencement selon la revendication 17, et
- la déconnexion de moyens, disposés pour la déconnexion, lors de la charge de ladite au moins une batterie de démarrage (330), ladite au moins une batterie de démarrage (330) à partir desdits moyens de charge de batterie lorsque ledit résultat de durée de charge a pris fin.
